# EUROPEAN PATENT APPLICATION

(11) **EP 3 890 143 A1**
(43) Date of publication of application: **06.10.2021**
(21) Application number: 19890539.0
(22) Date of filing: 25.10.2019
(51) Int. Cl.: H02J 7/00, H01M 10/44, H01M 10/48

(54) **BATTERY PACK AND ELECTRIC DEVICE SYSTEM**

(30) Priority: 30.11.2018 JP 2018224430
(71) Applicant: Koki Holdings Co., Ltd., Tokyo 108-6020 (JP)
(72) Inventor: YAMAGUCHI, Satoshi, Hitachinaka-City, Ibaraki 312-8502 (JP); YOSHIKAWA, Satoshi, Hitachinaka-City, Ibaraki 312-8502 (JP); HANAWA, Hiroyuki, Hitachinaka-City, Ibaraki 312-8502 (JP); FUNABASHI, Kazuhiko, Hitachinaka-City, Ibaraki 312-8502 (JP)
(74) Representative: Parker, Andrew James
(86) International application number: PCT/JP2019/041962
(87) International publication number: WO 2020/110542

(57) **Abstract**

The battery pack includes: a battery cell group; a control unit; and a battery-side LD terminal. The battery-side LD terminal common to the output of a charging prohibition signal and the output of a discharging prohibition signal is used. When charging is performed, the control unit does not output, to the battery-side LD terminal, the result of determining whether the battery cell group is in a discharging prohibition state or not, but outputs, to the battery-side LD terminal, the result of determining whether the battery cell group is in a charging prohibition state or not. Otherwise, the control unit does not output, to the battery-side LD terminal, the result of determining whether the battery cell group is in the charging prohibition state or not, but outputs, to the battery-side LD terminal, the result of determining whether the battery cell group is in the discharging prohibition state or not.

## Description

### BACKGROUND

### Technical Field

The present invention relates to a battery pack and an electric device system.

### Related Art

Patent literature 1 described below discloses a battery pack having a control unit and a battery pack cutoff signal terminal. In the battery pack, an overvoltage output terminal, an over-discharge output terminal, and the like of an integrated circuit (IC) for protection are connected to the control unit. The control unit controls a voltage applied to the battery pack cutoff signal terminal according to information from these terminals.

### Literature of related art

### Patent literature

Patent literature 1: Japanese Patent Laid-Open No. 2013-211980

### SUMMARY

### Problems to be Solved

The battery pack of Patent literature 1 does not disclose a terminal for outputting a charging prohibition signal to a charging device. If a separate terminal is arranged for the output of the charging prohibition signal, the number of terminals will increase.

The present invention has been made in recognition of the above situation, and an object of the present invention is to provide a battery pack that can suppress an increase in the number of terminals and a system equipped with the battery pack. In addition, another object of the present invention is to provide a battery pack having a single terminal with multiple functions and an electric device system equipped with the battery pack.

### Means to Solve Problems

One aspect of the present invention is a battery pack that is capable of being connected to an external device. The battery pack includes: a battery cell, a control unit for monitoring the state of the battery cell, and a signal terminal that is capable of outputting a charging/discharging prohibition signal to a charging device main body serving as the external device and outputting the charging/discharging prohibition signal to an electric device main body serving as the external device according to the state of the battery cell. The battery pack is configured to be charged by the charging device main body when it is connected to the charging device main body in a state that the charging/discharging prohibition signal is output. In addition, the battery pack is configured to discharge to the electric device main body when it is connected to the electric device main body in a state that the charging/discharging prohibition signal is output.

The charging/discharging prohibition signal may include a charging prohibition signal for prohibiting charging by the charging device main body and a discharging prohibition signal for prohibiting discharging performed by the electric device main body, and the charging prohibition signal and the discharging prohibition signal may have the same signal level. The battery pack may be configured to stop the charging/discharging prohibition signal or change the charging/discharging prohibition signal to a signal when the battery cell is normal when it is connected to the electric device main body in the state that the charging/discharging prohibition signal is output. The battery pack may be configured to stop the charging/discharging prohibition signal or change the charging/discharging prohibition signal to a signal when the battery cell is normal when it is connected to the charging device main body in the state that the charging/discharging prohibition signal is output. The discharging prohibition signal may be output from the control unit in a first cell state in which a voltage of the battery cell is lower than a first predetermined value, and the charging prohibition signal may be output from the control unit in a second cell state in which the voltage of the battery cell exceeds a second predetermined value which is larger than the first predetermined value.

When charging is performed, the control unit may not output the discharging prohibition signal to the signal terminal, but output the charging prohibition signal to the signal terminal according to the state of the battery cell.

Except when charging is performed, the control unit may not output the charging prohibition signal to the signal terminal, but output the discharging prohibition signal to the signal terminal according to the state of the battery cell.

The battery pack may include a communication terminal for communicating with the external device, and the control unit may determine whether or not charging is performed by communication using the communication terminal.

The control unit may determine that charging is not performed when it does not receive a signal indicating that charging is performed in a predetermined time at the communication terminal.

The battery pack may include a plurality of terminals that are connected to the external device. The plurality of terminals may have a positive electrode terminal, a negative electrode terminal, a communication terminal for communicating between the control unit and the external device, and the electric signal terminal. In addition, each of the communication terminal and the new language terminal may be a single terminal.

Another aspect of the present invention is an electric device system including the battery pack and the electric device main body that is capable of being connected to the battery pack. The electric device main body includes a control unit, and a plurality of device-side terminals which are connected to the signal terminal of the battery pack and to which the discharging prohibition signal is input.

Another aspect of the present invention is an electric device system including the battery pack and the charging device main body for charging the battery pack. The charging device main body includes: a charging circuit, a control unit for controlling charging, and a device-side signal terminal which is connected to the signal terminal of the battery pack and to which the charging prohibition signal is input.

In the battery pack or the charging device, the charging prohibition signal and the discharging prohibition signal may have the same signal level.

The electric device system may include: a switch for switching the output and cutoff of charging power from the charging circuit to the battery pack, and a switching circuit for switching ON/OFF of the switch based on a signal indicating a result of determining whether or not charging is capable of being performed by the control unit and a signal received by the signal terminal. The switching circuit may turn on the switch when the signal indicating the determined result is at a level that indicates charging is capable of being performed and the signal received by the signal terminal is at a level indicating charging permission, and turn off the switch otherwise.

The electric device system may include a cutoff circuit that cuts off a signal input from the signal terminal to the switching circuit when the voltage of the battery pack is equal to or lower than a predetermined value.

The predetermined value may be larger than a voltage value at which the control unit of the battery pack can be started.

Another aspect of the present invention is an electric device system. The electric device system includes the battery pack, the electric device main body that is capable of being connected to the battery pack, and the charging device main body for charging the battery pack. The electric device main body includes a device-side control unit, a device-side signal terminal which is connected to the signal terminal of the battery pack and to which the discharging prohibition signal is input. The charging device main body has a charging circuit, a charger-side control unit for controlling charging, and a charger-side signal terminal which is connected to the signal terminal and to which the charging prohibition signal is input.

Another aspect of the present invention is an electric device system. The electric device system includes a battery pack, an electric device main body that is capable of being connected to the battery pack, and a charging device main body for charging the battery pack. The battery pack includes a battery cell, a control unit for monitoring the state of the battery cell, and a signal terminal that is capable of outputting a charging/discharging prohibition signal to the charging device main body and outputting the charging/discharging prohibition signal to the electric device main body according to the state of the battery cell. The electric device main body includes a device-side control unit, and a device-side signal terminal which is connected to the signal terminal of the battery pack and to which the charging/discharging prohibition signal is input. The charging device main body includes a charging circuit, a charger-side control unit for controlling charging, and a charger-side signal terminal which is connected to the signal terminal and to which the charging/discharging prohibition signal is input. The electric device system is configured to stop the charging/discharging prohibition signal or change the charging/discharging prohibition signal to a signal when the battery pack is normal when the battery pack is connected to the electric tool main body in a state that the charging/discharging prohibition signal is output from the battery pack. The electric device system is configured to stop the charging/discharging prohibition signal or change the charging/discharging prohibition signal to a signal when the battery pack is normal when the battery pack is connected to the charging device main body in the state that the charging/discharging prohibition signal is output from the battery pack. Moreover, any combination of the above components, a conversion of the expression of the present invention between methods, and the like are also effective as aspects of the present invention.

### Effect

According to the present invention, it is possible to provide a battery pack that can suppress an increase in the number of terminals and an electric device system equipped with the battery pack. In addition, it is possible to provide a battery pack having a single terminal with multiple functions and an electric device system equipped with the battery pack.

### BRIEF DESCRIPTION OF THE DRAWINGS

FIG. 1 is a circuit block diagram of an electric device system (charging system) 1 according to a first embodiment of the present invention.
FIG. 2 is a circuit block diagram showing a state in which a battery pack 50 of FIG. 1 is connected to an electric device main body 80 having a control unit 89.
FIG. 3 is a circuit block diagram showing a state in which the battery pack 50 of FIG. 1 is connected to an electric device main body 90 having no control unit.
FIG. 4 is a time chart showing an example of operation of the electric device system (charging system) 1.
FIG. 5 is a flowchart of operation of the battery pack 50.
FIG. 6 is a flowchart of operation of a charging device 10 in a standby mode.
FIG. 7 is a flowchart of operation of the charging device 10 in a charging mode.
FIG. 8 is a flowchart of operation of the charging device 10 in a charging completion mode.
FIG. 9 is a circuit block diagram of an electric device system (charging system) 2 according to a second embodiment of the present invention.
FIG. 10 is a time chart showing an example of operation of the electric device system (charging system) 2.
FIG. 11 is a flowchart of operation of a charging device 10A in the charging mode.

### DESCRIPTION OF THE EMBODIMENTS

Hereinafter, preferred embodiments of the present invention are described in detail with reference to the drawings. The same or equivalent components, members, processing, and the like shown in each figure are designated by the same reference signs, and redundant description is omitted as appropriate. In addition, the embodiments are illustrative and are not intended to limit the invention, and all the features and combinations thereof described in the embodiment are not necessarily essential to the invention.

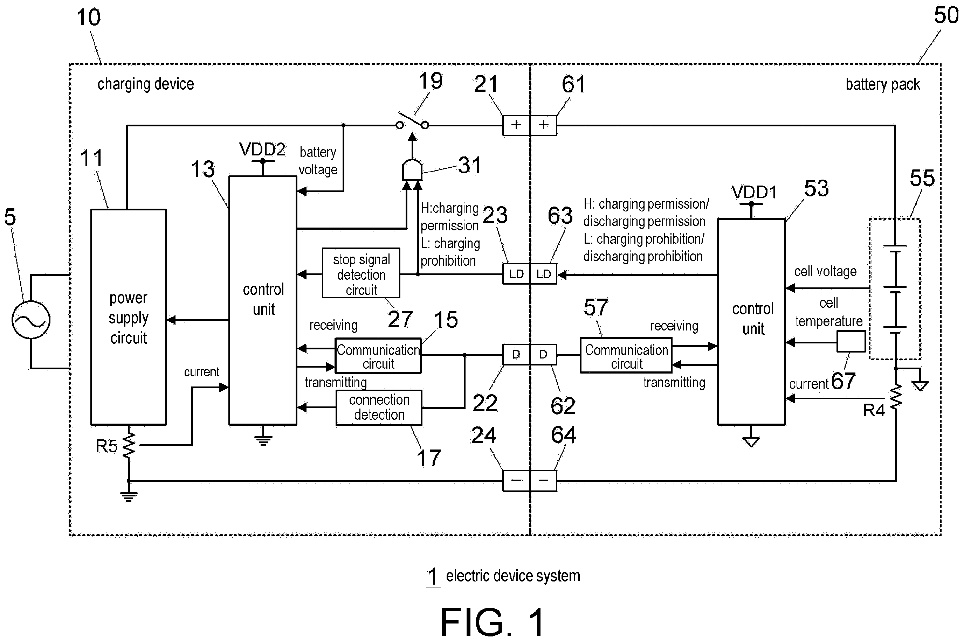

(Embodiment 1) FIG. 1 is a circuit block diagram of an electric device system (charging system) 1 according to a first embodiment of the present invention. The electric device system (charging system) 1 includes a charging device 10 (charging device main body) serving as an external device and a battery pack 50. The charging device 10 has, for connection with the battery pack 50, a device-side positive terminal 21, a device-side D terminal 22 serving as a device-side communication terminal, a device-side LD terminal 23 serving as a device-side signal terminal (charger-side signal terminal), and a device-side negative terminal 24. The battery pack 50 has a battery-side positive terminal 61, a battery-side D terminal 62 serving as a battery-side communication terminal, a battery-side LD terminal 63 serving as a battery-side signal terminal, and a battery-side negative terminal 64. The device-side positive terminal 21 and the battery-side positive terminal 61 are connected to each other. The device-side D terminal 22 and the battery-side D terminal 62 are connected to each other. The device-side LD terminal 23 and the battery-side LD terminal 63 are connected to each other. The device-side negative terminal 24 and the battery-side negative terminal 64 are connected to each other. Moreover, each of the D terminal and the LD terminal is constituted of only a single terminal.

The charging device 10 has a power supply circuit 11, a control unit (device-side control unit and charger-side control unit) 13, a communication circuit 15, a connection detection circuit 17, a switch 19, a stop signal detection circuit 27, and an AND circuit 31 serving as a switching circuit. The power supply circuit 11 converts an AC voltage supplied from an external AC power supply 5 such as a commercial power supply into a DC voltage for charging the battery pack 50 and outputs the DC voltage to the device-side positive terminal 21, and converts the AC voltage into a DC voltage VDD2 for control and supplies the DC voltage VDD2 to each circuit of the charging device 10. The control unit 13 controls the whole operation of the charging device 10. The communication circuit 15 is connected to the device-side D terminal 22, and transmits and receives a communication signal to and from a communication circuit 57 of the battery pack 50 under the control of the control unit 13. The connection detection circuit 17 is connected to the device-side D terminal 22 and detects the presence or absence of connection detection of the battery pack 50. The switch 19 is, for example, a relay, and is opened and closed according to an output signal of the AND circuit 31. The switch 19 is turned on when the output signal of the AND circuit 31 is at a high level, and is turned off when the output signal is at a low level. The AND circuit 31 outputs a high level signal and turns on the switch 19 when both a relay ON/OFF signal (a signal indicating the result of determining whether or not charging can be performed) of the control unit 13 and a signal received by the device-side LD terminal 23 are at a high level, and outputs a low level signal and turns off the switch 19 when at least one of the relay ON/OFF signal of the control unit 13 and the signal received by the device-side LD terminal 23 is at a low level. The stop signal detection circuit 27 detects whether or not charging is permitted based on an input signal from the device-side LD terminal 23. The charging device 10 has a resistor R5 in the passage of the charging current. The control unit 13 detects the charging current by the voltage at both ends of the resistor R5. The control unit 13 detects the voltage of the battery pack 50 by the voltage of the device-side positive terminal 21.

The battery pack 50 has a power supply circuit (not shown), a control unit (battery-side control unit) 53, a battery cell group 55, the communication circuit 57, and a temperature detection element 67. The power supply circuit converts the output voltage of the battery cell group 55 into a DC voltage VDD1 for control and supplies the DC voltage VDD1 to each circuit of the battery pack 50. When the switch 19 of the charging device 10 is turned on, the power supply circuit converts the output voltage of the power supply circuit 11 of the charging device 10 into a DC voltage VDD1 for control and supplies the DC voltage VDD1 to each circuit of the battery pack 50. The control unit 53 controls the whole operation of the battery pack 50. The battery cell group 55 has a plurality of battery cells. The communication circuit 57 is connected to the battery-side D terminal 62, and transmits and receives a communication signal to and from the communication circuit 15 of the charging device 10 under the control of the control unit 53. Although not shown, a connection detection circuit may be arranged at the battery-side D terminal 62 to detect the presence or absence of connection detection of the charging device 10 or other electric devices. In addition, a discriminating resistor having a resistance value according to information of the battery pack 50 (rated voltage, number of connected cells, connection form of the cells, or the like) may be arranged between the battery-side D terminal 62 and the ground. The temperature detection element 67 is, for example, a thermistor, and is arranged in the vicinity of the battery cell group 55 to detect the temperature of the battery cell group 55. The control unit 53 monitors the voltage of each cell of the battery cell group 55. The battery pack 50 has a resistor R4 in the passage of the discharging current. The control unit 53 detects the discharging current by the voltage at both ends of the resistor R4.

The control unit 53 monitors the state of the battery cell group 55 (temperature of the battery cell group 55, voltage of each cell, and the like), and determines whether or not charging is permitted and discharging is permitted according to the state of the battery cell. In the case of charging permission and discharging permission, the control unit 53 outputs a high level signal (charging permission signal and discharging permission signal corresponding to a first signal state) to the battery-side LD terminal 63. In the case of charging rejection and discharging rejection, the control unit 53 outputs a low level signal (charging prohibition signal and discharging prohibition signal corresponding to a second signal state) to the battery-side LD terminal 63. When charging is performed, the control unit 53 does not output, to the battery-side LD terminal 63, the result of determining whether the battery cell group 55 is in a discharging prohibition state or not, but outputs, to the battery-side LD terminal 63, the result of determining whether the battery cell group 55 is in a charging prohibition state or not. That is, when charging is performed, the control unit 53 does not output the discharging prohibition signal to the battery-side LD terminal 63, or changes the discharging prohibition signal to a signal when the state of the battery cell group 55 is normal (normal signal), and outputs a charging prohibition signal to the battery-side LD terminal 63 according to the state of the battery cell group 55. Except when charging is performed, the control unit 53 does not output, to the battery-side LD terminal 63, the result of determining whether the battery cell group 55 is in a charging prohibition state or not, but outputs, to the battery-side LD terminal 63, the result of determining whether the battery cell group 55 is in a discharging prohibition state or not. That is, except when charging is performed, the control unit 53 does not output the charging prohibition signal to the battery-side LD terminal 63, or changes the charging prohibition signal to a signal when the state of the battery cell group 55 (normal signal), and outputs the discharging prohibition signal to the battery-side LD terminal 63 according to the state of the battery cell group 55. The control unit 53 determines whether or not charging is performed by communication using the battery-side D terminal 62 (communication with the control unit 13 of the charging device 10). The control unit 53 determines that charging is not performed when it does not receive a signal indicating that charging is performed in a predetermined time at the battery-side D terminal 62. A discriminating resistor (not shown) may be arranged in the charging device 10, and the control unit 53 may determine whether or not the charging device 10 is connected to the battery pack 50 by using the discriminating resistor. When determining that the charging device 10 is connected to the battery pack 50, the control unit 53 may determine that charging is performed. Here, because both the charging prohibition signal and the discharging prohibition signal are output to the external device via a common LD terminal 63, these signals may be collectively referred to as charging/discharging prohibition signals hereinafter.

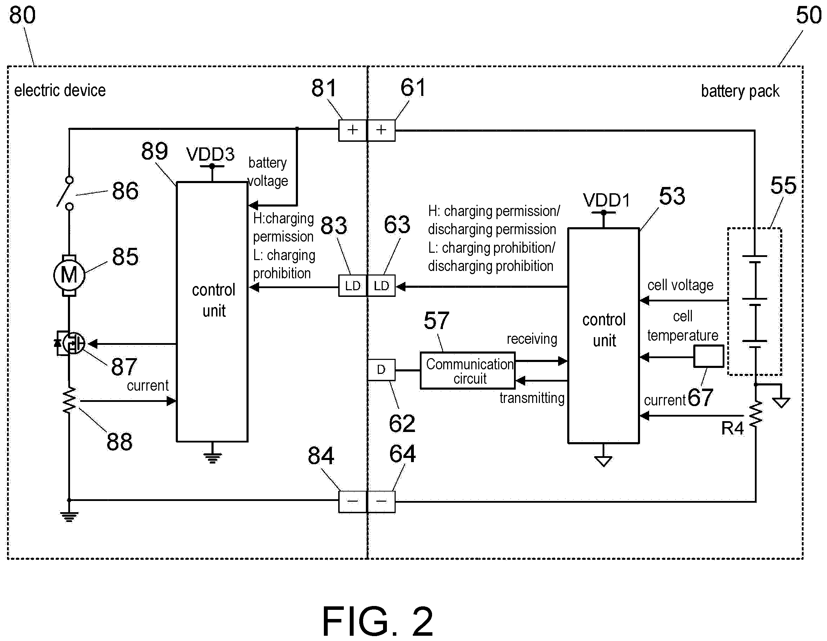

FIG. 2 is a circuit block diagram showing a state in which the battery pack 50 of FIG. 1 is connected to an electric device 80 (electric device main body) serving as an external device that has a control unit 89 (device-side control unit). The electric device 80 is, for example, an electric tool (electric tool body). The electric device 80 has, for connection with the battery pack 50, a device-side positive terminal 81, a device-side LD terminal 83 serving as a device-side signal terminal, and a device-side negative terminal 84. The device-side positive terminal 81 and the battery-side positive terminal 61 are connected to each other. The device-side LD terminal 83 and the battery-side LD terminal 63 are connected to each other. The device-side negative terminal 84 and the battery-side negative terminal 64 are connected to each other. The electric device 80 has a switch 86, a motor 85, a switching element 87, and a resistor 88, which are connected in series between the device-side positive terminal 81 and the device-side negative terminal 84. The switch 86 is a switch that is turned on and off by an operator. The switching element 87 is a switch which is turned on and off by the control unit 89 according to an input signal from the device-side LD terminal 83. The control unit 89 turns on (conducts) the switching element 87 when the input signal from the device-side LD terminal 83 is at a high level, and turns off (cuts off) the switching element 87 when the input signal is at a low level. The control unit 89 detects the current flowing through the motor 85 by the voltage at both ends of the resistor 88. The control unit 89 detects the output voltage of the battery pack 50 by the voltage of the device-side positive terminal 81.

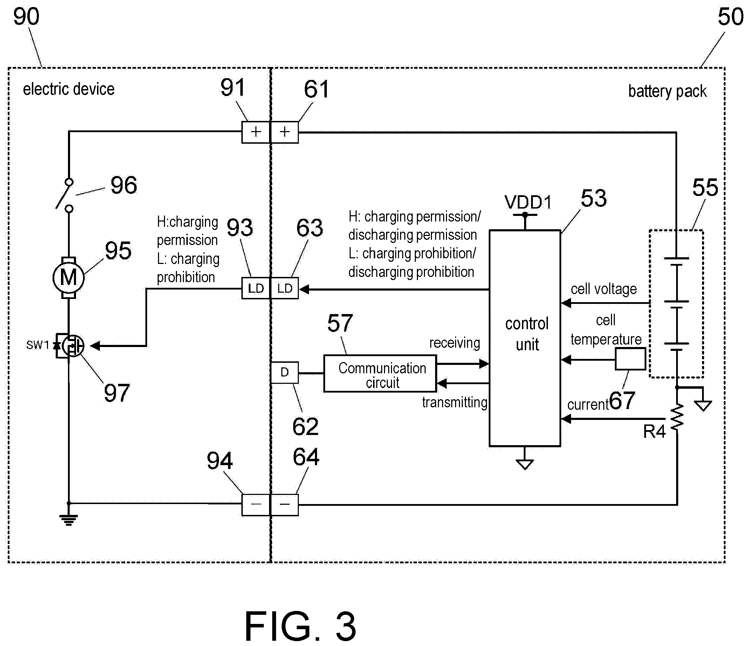

FIG. 3 is a circuit block diagram showing a state in which the battery pack 50 of FIG. 1 is connected to an electric device 90 (electric device main body) serving as an external device having no control unit corresponding to the control unit 89 of FIG. 2. The electric device 90 is, for example, an electric tool (electric tool body). The electric device 90 has, for connection with the battery pack 50, a device-side positive terminal 91, a device-side LD terminal 93 serving as a device-side signal terminal, and a device-side negative terminal 94. The device-side positive terminal 91 and the battery-side positive terminal 61 are connected to each other. The device-side LD terminal 93 and the battery-side LD terminal 63 are connected to each other. The device-side negative terminal 94 and the battery-side negative terminal 64 are connected to each other. The electric device 90 has a switch 96, a motor 95, and a switching element 97, which are connected in series between the device-side positive terminal 91 and the device-side negative terminal 94. The switch 96 is a switch that is turned on and off by an operator. The switching element 97 is a switch that is turned on and off according to an input signal from the device-side LD terminal 93. The switching element 97 is turned on when the input signal from the device-side LD terminal 93 is at a high level, and is turned off when the input signal from the device-side LD terminal 93 is at a low level. Moreover, the switching element 97 may be used as a control unit.

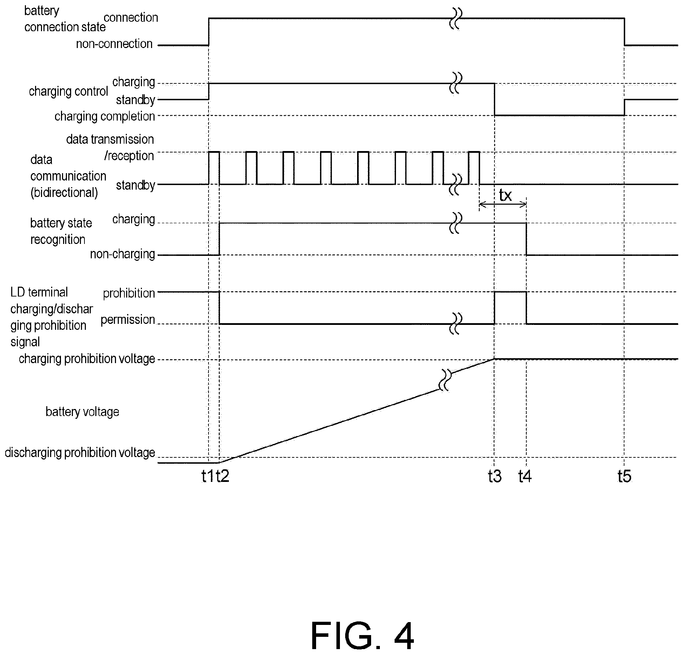

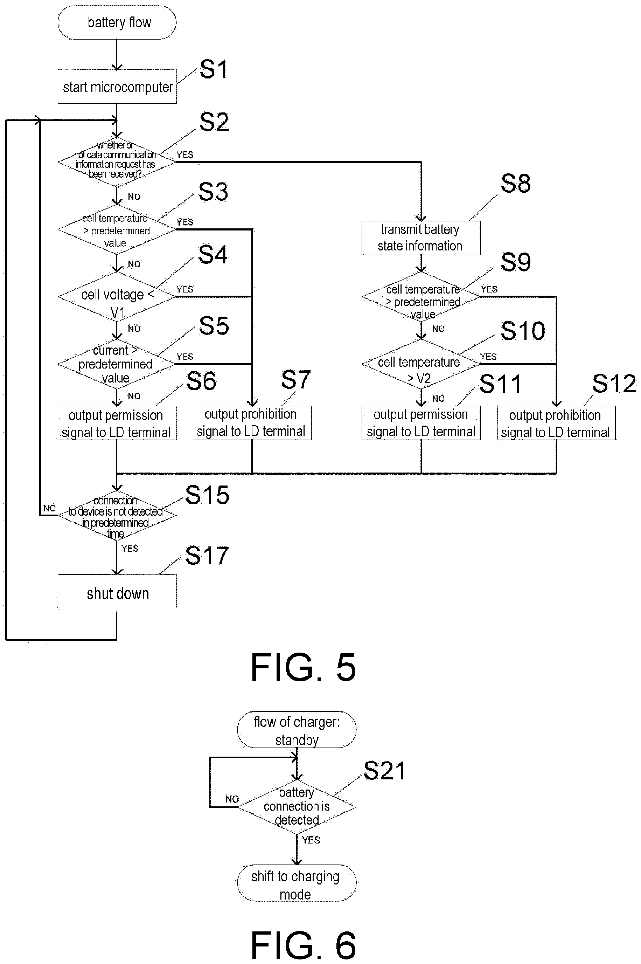

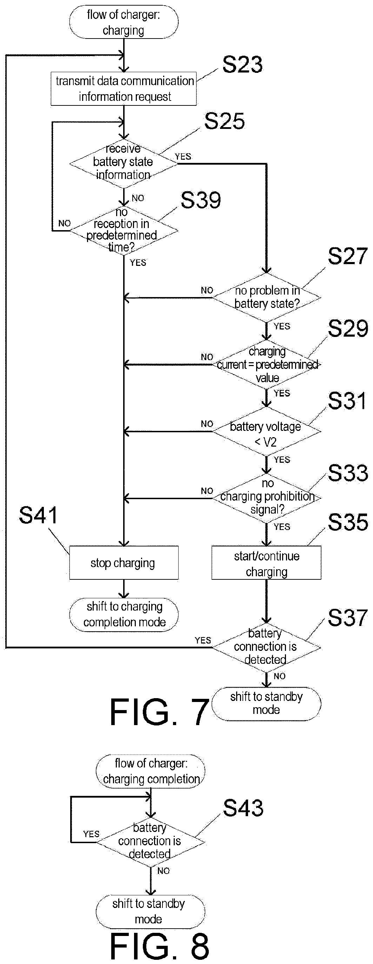

FIG. 4 is a time chart showing an example of operation of the system (charging system) 1. Before time t1, the battery pack 50 is not connected to the charging device 10, the control unit 13 of the charging device 10 is in a standby mode (FIG. 6), and the state recognition of the control unit 53 of the battery pack 50 is non-charging (except when charging is performed). Because the voltage of the battery pack 50 is lower than a discharging prohibition voltage, the control unit 53 outputs a discharging prohibition signal (a voltage signal having the same level as the charging prohibition signal) to the battery-side LD terminal 63. When the battery pack 50 is connected to the charging device 10 at time t1, the control unit 13 of the charging device 10 enters a charging mode (FIG. 7), and transmits, to the control unit 53 of the battery pack 50, a signal indicating that charging is performed. The control unit 53 receives, from the charging device 10, the signal indicating that charging is performed, and determines that the state recognition is charging (when charging is performed) at time t2. The control unit 53 stops the output of the discharging prohibition signal to the battery-side LD terminal 63 (stops the output of the result of determining whether or not discharging is prohibited) when the state is recognized as charging, and outputs the charging permission signal (a voltage signal having the same level as the discharging permission signal) to the battery-side LD terminal 63.

After time t2, a charging voltage and a charging current are supplied from the power supply circuit 11 of the charging device 10 to the battery cell group 55 of the battery pack 50, and the battery pack 50 is being charged. During the charging period, communication by the communication circuit 15 and the communication circuit 57 (communication between the control unit 13 and the control unit 53) is performed. During the communication, the signal indicating that charging is performed is transmitted from the control unit 13 to the control unit 53, and the temperature of the battery cell group 55, the voltage of each cell, and the like are transmitted from the control unit 53 to the control unit 13. When charging is completed at time t3 (when the voltage of the battery pack 50 reaches a charging prohibition voltage being a full charge voltage), the control unit 13 of the charging device 10 enters a charging completion mode (FIG. 8), and the control unit 53 of the battery pack 50 outputs the charging prohibition signal to the battery-side LD terminal 63. The control unit 53 sets the state recognition as non-charging (except when charging is performed) at time t4 when a predetermined time tx has elapsed since the signal indicating that charging is performed was received finally. The control unit 53 stops the output of the charging prohibition signal to the battery-side LD terminal 63 (stops the output of the result of determining whether or not charging is prohibited) when the state is recognized as non-charging, and outputs the discharging permission signal to the battery-side LD terminal 63. When the battery pack 50 is removed from the charging device 10 at time t5, the control unit 13 shifts to the standby mode (FIG. 6).

FIG. 5 is a flowchart of operation of the battery pack 50. The control unit 53 is connected to an electric device such as the charging device 10 and is started (S1). For example, the power supply circuit (not shown) of the battery pack 50 is started by receiving a start-up signal, and the control unit 53 is started by supplying an operating voltage from the power supply circuit to the control unit 53. A dedicated terminal or the battery-side D terminal 62 may be used for receiving the start-up signal. The control unit 53 determines that charging is not performed when it does not receive a data communication information request from an electric device (for example, the control unit 13 of the charging device 10) connected at the battery-side D terminal 62 (NO in S2). When the temperature of the battery cell group 55 is below a predetermined value (NO in S3), the voltage of each battery cell is equal to or higher than a first predetermined value V1 (NO in S4), and the discharging current is below a predetermined value (NO in S5), the control unit 53 outputs the discharging permission signal to the battery-side LD terminal 63 (S6). When the temperature of the battery cell exceeds the predetermined value (YES in S3), or when the voltage of at least one battery cell is lower than the first predetermined value V1 (YES in S4), or when the discharging current exceeds the predetermined value (YES in S5), the control unit 53 outputs the discharging prohibition signal to the battery-side LD terminal 63 (S7). Moreover, the first predetermined value V1 is a voltage value for determining that the battery cell is over-discharged. In addition, the state in which the discharging prohibition signal is output corresponds to a first cell state.

When receiving a data communication information request from the electric device connected at the battery-side D terminal 62 (YES in S2), the control unit 53 determines that charging is performed, and transmits the state of the battery cell group 55 (the temperature of the battery cell group 55, the voltage of each cell, and the like) from the battery-side D terminal 62 to the electric device (S8). When the temperature of the battery cell group 55 is equal to or lower than a predetermined value (NO in S9) and the voltage of each battery cell is equal to or lower than a second predetermined value V2 (NO in S10), the control unit 53 outputs the charging permission signal to the battery-side LD terminal 63 (S11). When the temperature of the battery cell exceeds the predetermined value (YES in S9) or when the voltage of at least one battery cell exceeds the second predetermined value V2 (YES in S10), the control unit 53 outputs the charging prohibition signal to the battery-side LD terminal 63 (S12). The control unit 53 shuts down (S17) when the connection to the electric device such as the charging device 10 is not detected in a predetermined time (YES in S15). The shutdown is performed, for example, by stopping the power supply circuit (not shown) of the battery pack 50. Moreover, the second predetermined value V2 is a voltage value for determining that the battery cell is fully charged. In addition, the state in which the charging prohibition signal is output corresponds to a second cell state.

FIG. 6 is a flowchart of operation of the charging device 10 in the standby mode. The control unit 13 shifts to the charging mode when the connection of the battery pack 50 is detected (YES in S21).

FIG. 7 is a flowchart of operation of the charging device 10 in the charging mode. The control unit 13 transmits a battery state information request from the communication circuit 15 to the battery pack 50 via the D terminals 22 and 62 (S23). When the battery state information is received from the battery pack 50 via the D terminals 22 and 62 (YES in S25), if there is no problem in the state (temperature, or the like) of the battery pack 50 (YES in S27), the charging current is within a predetermined value or a predetermined range (YES in S29), the voltage of the battery pack 50 is lower than a full charge voltage V2 (YES in S31), and no charging prohibition signal is received from the battery pack 50 via the LD terminals 23 and 63 (YES in S33), the control unit 13 starts and continues charging the battery pack 50 (S35). When the battery pack 50 is removed from the charging device 10 (NO in S37), the control unit 13 shifts to the standby mode (FIG. 6). The control unit 13 stops charging the battery pack 50 (S41) and shifts to the charging completion mode (FIG. 8) in any one of the following cases: the battery state information is not received in the predetermined time in step S25 (NO in S25, YES in S39); there is a problem in the state of the battery pack 50 (NO in S27); the charging current is not within a predetermined value or a predetermined range (NO in S29); the voltage of the battery pack 50 is equal to or higher than the full charge voltage V2 (NO in S31); and the charging prohibition signal is received from the battery pack 50 via the LD terminals 23 and 63 (NO in S33).

FIG. 8 is a flowchart of operation of the charging device 10 in the charging completion mode. The control unit 13 shifts to the standby mode when no longer detecting the connection of the battery pack 50 (NO in S43).

According to the embodiment, the following effects can be obtained.
(1) the device-side LD terminal 23 and the battery-side LD terminal 63 are shared for transmitting and receiving the charging permission signal and the discharging permission signal, as well as the charging prohibition signal and the discharging prohibition signal, and thus the number of terminals can be reduced.
(2) When charging is performed, the control unit 53 of the battery pack 50 does not output, to the battery-side LD terminal 63, the result of determining whether the battery cell group 55 is in a discharging prohibition state or not, but outputs, to the battery-side LD terminal 63, the result of determining whether the battery cell group 55 is in a charging prohibition state or not, and thus charging can be performed even when the voltage of the battery pack 50 is equal to or lower than the discharging prohibition voltage (even when the battery pack 50 is over-discharged).
(3) Except when charging is performed, the control unit 53 does not output, to the battery-side LD terminal 63, the result of determining whether the battery cell group 55 is in a charging prohibition state or not, but output, to the battery-side LD terminal 63, the result of determining whether the battery cell group 55 is in a discharging prohibition state or not, and thus discharging can be performed even when the voltage of the battery pack 50 is equal to or higher than the charging prohibition voltage. In addition, the electric device other than the charging device 10 (the electric device to be the discharge destination of the battery pack 50) does not need to have a configuration for notifying the battery pack 50 that discharging is performed, and the configuration can be simplified.
(4) The control unit 13 of the charging device 10 does not perform charging when there is no communication response from the battery pack 50, and thus it is possible to prevent the battery pack 50 from being charged without the overcharge protection being enabled because the control unit of the battery pack 50 cannot recognize that charging is performed. In addition, only the battery pack 50 that can perform a predetermined data communication is to be charged, and thus it is difficult to imitate.

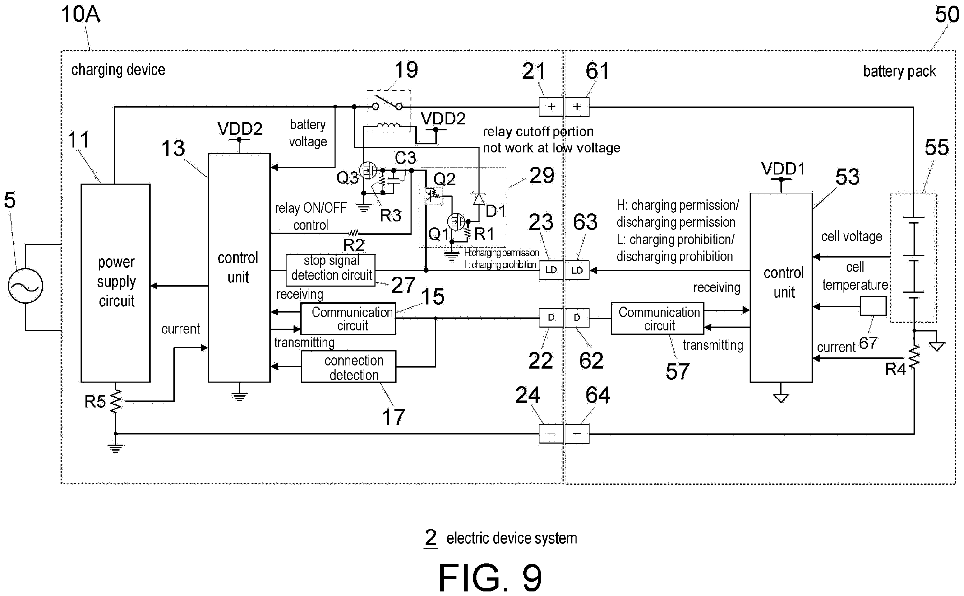

(Embodiment 2) FIG. 9 is a circuit block diagram of an electric device system (charging system) 2 according to a second embodiment of the present invention. The charging system 2 is the same as that of the first embodiment shown in FIG. 1 except that the charging device 10 is replaced with the charging device 10A (charging device main body). Hereinafter, the portion of the charging device 10A that is different from the charging device 10 is mainly described.

The charging device 10A has a cutoff circuit 29 serving as a switching circuit. The cutoff circuit 29 cuts off a signal input from the device-side LD terminal 23 to the gate (control terminal) of a switching element Q3 such as a field effect transistor (FET) or the like when the voltage of the battery pack 50 is equal to or lower than a predetermined value. The predetermined value is larger than a voltage value at which the control unit 53 of the battery pack 50 can be started. The switching element Q3, a capacitor C3, resistors R2 and R3 are examples of the specific configuration of the AND circuit 31 in FIG. 1.

The switch 19 is a relay that is turned on when current flows through the coil portion. One end of the coil portion of the switch 19 is connected to a power supply line to which a power supply voltage VDD2 is supplied. The other end of the coil portion is connected to a drain of the switching element Q3. The source of the switching element Q3 is connected to the ground. The resistor R3 and the capacitor C3 are connected in parallel between the gate and source of the switching element Q3. The gate of the switching element Q3 is connected to an emitter of a switching element Q2. A collector of the switching element Q2 is connected to the device-side LD terminal 23. The base (control terminal) of the switching element Q2 is connected to a drain of a switching element Q1. The source of the switching element Q1 is connected to the ground. A resistor R1 is connected between the gate (control terminal) and source of the switching element Q1. The gate of the switching element Q1 is connected to the anode of a Zener diode D1. The cathode of the Zener diode D1 is connected to an output terminal in the power supply circuit 11. The cathode of the Zener diode D1 is connected to the device-side positive terminal 21 via the switch portion of the switch 19.

When the voltage of the battery pack 50 is smaller than a sum of a gate threshold voltage (a voltage at which the switching element Q1 is turned on) Vth of the switching element Q1 and a voltage Vz of the Zener diode D1 (Vth + Vz), the switching element Q1 is turned off, and thus the switching element Q2 is also turned off. Therefore, the signal input from the device-side LD terminal 23 to the gate of the switching element Q3 is cut off by the switching element Q2. Thus, if the control unit 13 applies, to the gate of the switching element Q3, a high level signal indicating the result of determining that charging can be performed, the switching element Q3 is turned on, a current flows through the coil portion of the switch 19, and the switch portion of the switch 19 is turned on. On the other hand, when the voltage of the battery pack 50 is equal to or higher than a sum of the voltage Vz of the Zener diode D1 and the gate threshold voltage Vth of the switching element Q1 (Vth + Vz), the switching element Q1 is turned on and the switching element Q2 is also turned on. Therefore, the signal input from the device-side LD terminal 23 to the gate of the switching element Q3 is not cut off. In this case, even when the control unit 13 outputs a high level signal toward the gate of the switching element Q3, if the device-side LD terminal 23 is at a low level, the gate potential of the switching element Q3 becomes a low level due to a voltage drop at the resistor R2 and the switching element Q3 is not turned on.

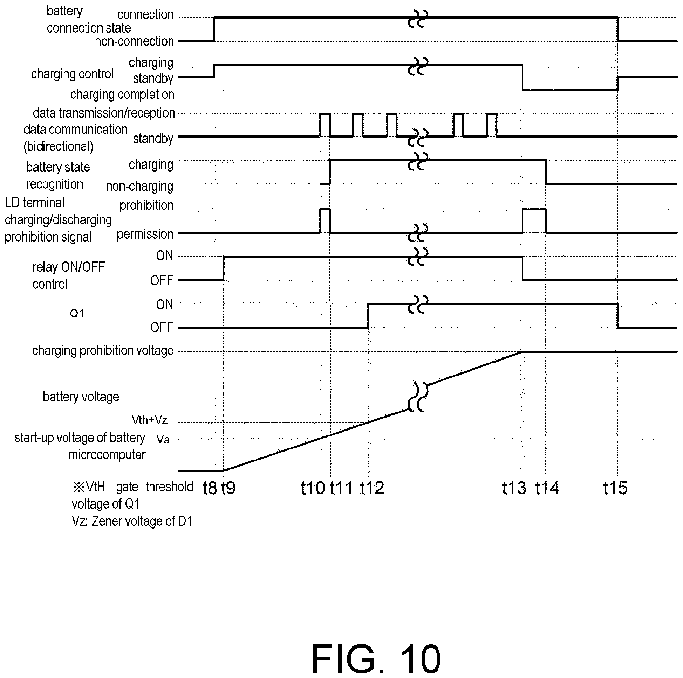

FIG. 10 is a time chart showing an example of operation of the charging system 2. Before time t8, the battery pack 50 is not connected to the charging device 10A, and the control unit 13 of the charging device 10A is in the standby mode (FIG. 6). When the battery pack 50 is connected to the charging device 10A at time t8, the control unit 13 of the charging device 10A enters the charging mode (FIG. 7). The voltage of the battery pack 50 is lower than a voltage Va required for the start of the control unit 53 of the battery pack 50. Therefore, the control unit 13 cannot communicate with the control unit 53 of the battery pack 50. In this case, the control unit 13 turns on the switch 19 at time t9 and starts charging.

When the voltage of the battery pack 50 is equal to or higher than Va at time t10, the control unit 53 of the battery pack 50 is started. The control unit 53 recognizes that charging is not performed and the voltage Va is lower than the discharging prohibition voltage until it recognizes that charging is performed by communication. Therefore, the control unit 53 outputs the discharging prohibition signal to the battery-side LD terminal 63. In the charging device 10A, although the discharging prohibition signal is input to the device-side LD terminal 23, the discharging prohibition signal is cut off by the cutoff circuit 29 due to Va < Vth + Vz. The control unit 13 applies, to the gate of the switching element Q3, a high level signal indicating the result of determining that charging can be performed, and charging is continued even after time t10. At time t10, communication is started between the control unit 13 of the charging device 10A and the control unit 53 of the battery pack 50, and at time t11, the control unit 53 sets the state recognition as charging (when charging is performed). The control unit 53 stops the output of the discharging prohibition signal to the battery-side LD terminal 63 (stops the output of the result of determining whether or not discharging is prohibited) when the state is recognized as charging, and outputs the charging permission signal (a voltage signal having the same level as the discharging permission signal) to the battery-side LD terminal 63.

When the voltage of the battery pack 50 is equal to or higher than Vth + Vz at time t12, the switching element Q1 is turned on and the cutoff by the cutoff circuit 29 is released. When charging is completed at time t13 (when the voltage of the battery pack 50 reaches the charging prohibition voltage being the full charge voltage), the control unit 13 of the charging device 10A enters the charging completion mode (FIG. 8), and the control unit 53 of the battery pack 50 outputs the charging prohibition signal to the battery-side LD terminal 63. Accordingly, the stop signal detection circuit 27 detects the charging prohibition signal, and the control unit 13 outputs, to the control terminal of the switching element Q3, a signal for turning off a relay 19, to thereby turn off the switch 19. The control unit 53 sets the state recognition as non-charging (except when charging is performed) at time t14 when a predetermined time has elapsed since the signal indicating that charging is performed was received finally. The control unit 53 stops the output of the charging prohibition signal to the battery-side LD terminal 63 (stops the output of the result of determining whether or not charging is prohibited) when the state is recognized as non-charging, and outputs the discharging permission signal to the battery-side LD terminal 63. When the battery pack 50 is removed from the charging device 10A at time t15, the control unit 13 shifts to the standby mode (FIG. 6), and the switching element Q1 is turned off.

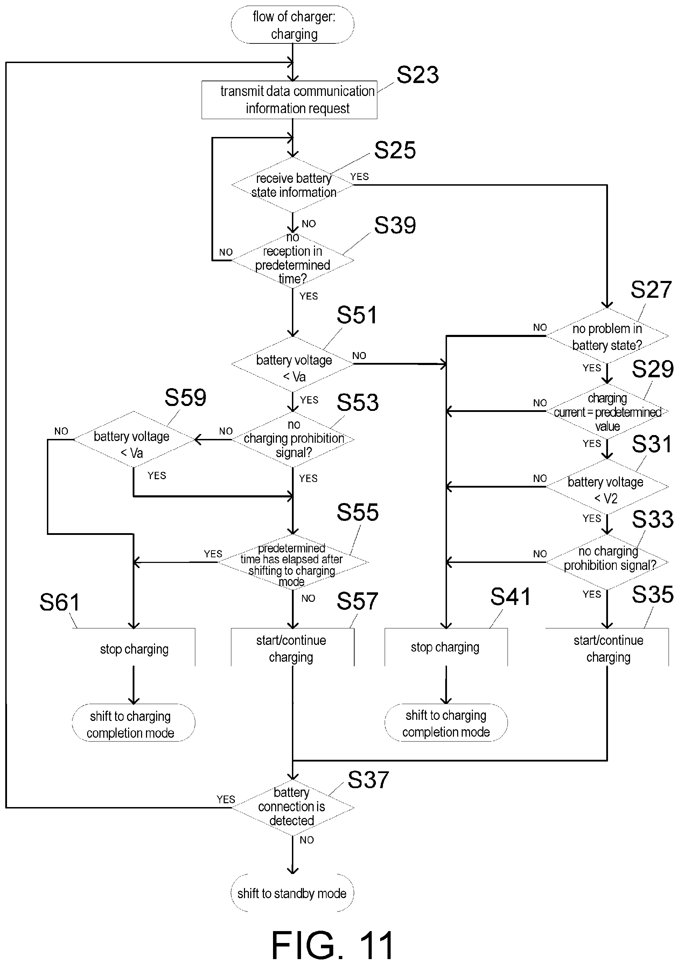

FIG. 11 is a flowchart of operation of the charging device 10A in the charging mode. Hereinafter, the differences from FIG. 7 are mainly described. When the battery state information is not received from the battery pack 50 in a predetermined time in step S25 (NO in S25, YES in S39), if the voltage of the battery pack 50 is lower than Va (YES in S51), no charging prohibition signal is received at the device-side LD terminal 23 (YES in S53), and a predetermined time has not elapsed after shifting to the charging mode (NO in S55), the control unit 13 starts and continues charging the battery pack 50 (S57). When the voltage of the battery pack 50 is equal to or higher than Va in step S51 (NO in S51), the control unit 13 stops charging the battery pack 50 (S41) and shifts to the charging completion mode (FIG. 8). When the control unit 13 receives the charging prohibition signal at the device-side LD terminal 23 in step S53 (NO in S53) and the voltage of the battery pack 50 is equal to or higher than Va (NO in S59), the control unit 13 stops charging the battery pack 50 (S61) and shifts to the charging completion mode (FIG. 8). When the voltage of the battery pack 50 is lower than Va in step S59 (YES in S59), the control unit 13 proceeds to step S55. In step S55, when a predetermined time has elapsed after shifting to the charging mode (YES in S55), the control unit 13 stops charging the battery pack 50 (S61) and shifts to the charging completion mode (FIG. 8).

According to the embodiment, the battery pack 50 can be suitably charged by the charging device 10A even when the battery pack 50 is over-discharged to the extent that the control unit 53 cannot be started by the voltage of the battery cell group 55. That is, the discharging prohibition signal is cut off by the cutoff circuit 29 in the charging device 10A even if the control unit 53 of the battery pack 50 is started and outputs the discharging prohibition signal to the battery-side LD terminal 63 during charging. Therefore, charging of the battery pack 50 can be continued without interruption under the control of the control unit 13.

Although the present invention has been described above by taking the embodiments as an example, it is understood by those skilled in the art that various modifications can be made to each component and each processing process of the embodiments within the scope of the claims. Reference Signs List

- 1, 2: system (charging system)
- 10, 10A: charging device
- 11: power supply circuit
- 13: control unit (device-side control unit)
- 15: communication circuit
- 17: connection detection circuit
- 19: switch
- 21: device-side positive terminal
- 22: device-side D terminal
- 23: device-side LD terminal
- 24: device-side negative terminal
- 27: stop signal detection circuit
- 29: cutoff circuit
- 31: AND circuit
- 50: battery pack
- 53: control unit (battery-side control unit)
- 55: battery cell group
- 57: communication circuit
- 61: battery-side positive terminal (positive terminal for charging)
- 62: battery-side D terminal
- 63: battery-side LD terminal
- 64: battery-side negative terminal
- 67: temperature detection element
- 80: electric device
- 81: device-side positive terminal
- 83: device-side LD terminal
- 84: device-side negative terminal
- 85: motor
- 86: switch
- 87: switching element
- 88: resistor
- 89: control unit (device-side control unit)
- 90: electric device
- 91: device-side positive terminal
- 93: device-side LD terminal
- 94: device-side negative terminal
- 95: motor
- 96: switch
- 97: switching element

## Claims

1. A battery pack that is capable of being connected to an external device, the battery pack comprising:
a battery cell;
a control unit for monitoring the state of the battery cell; and
a signal terminal that is capable of outputting a charging/discharging prohibition signal to a charging device main body serving as the external device and outputting the charging/discharging prohibition signal to an electric device main body serving as the external device according to the state of the battery cell,
wherein the battery pack is configured to be charged by the charging device main body when the battery pack is connected to the charging device main body in a state that the charging/discharging prohibition signal is output, or discharge to the electric device main body when the battery pack is connected to the electric device main body in the state that the charging/discharging prohibition signal is output.

2. The battery pack according to claim 1, wherein the charging/discharging prohibition signal comprises a charging prohibition signal for prohibiting charging by the charging device main body and a discharging prohibition signal for prohibiting discharging performed by the electric device main body, and
the charging prohibition signal and the discharging prohibition signal have the same signal level.

3. The battery pack according to claim 1 or 2, wherein the battery pack is configured to stop the charging/discharging prohibition signal or change the charging/discharging prohibition signal to a signal when the battery cell is normal when the battery pack is connected to the electric device main body in the state that the charging/discharging prohibition signal is output, or
the battery pack is configured to stop the charging/discharging prohibition signal or change the charging/discharging prohibition signal to a signal when the battery cell is normal when the battery pack is connected to the charging device main body in the state that the charging/discharging prohibition signal is output.

4. The battery pack according to claim 2 or 3, wherein the discharging prohibition signal is output from the control unit in a first cell state in which a voltage of the battery cell is lower than a first predetermined value, and the charging prohibition signal is output from the control unit in a second cell state in which the voltage of the battery cell exceeds a second predetermined value which is larger than the first predetermined value.

5. The battery pack according to any one of claims 2 to 4, wherein when charging is performed, the control unit does not output the discharging prohibition signal to the signal terminal, but outputs the charging prohibition signal to the signal terminal according to the state of the battery cell.

6. The battery pack according to any one of claims 2 to 5, wherein except when charging is performed, the control unit does not output the charging prohibition signal to the signal terminal, but outputs the discharging prohibition signal to the signal terminal according to the state of the battery cell.

7. The battery pack according to any one of claims 1 to 6, comprising:
a plurality of terminals that are connected to the external device,
wherein the plurality of terminals have a positive electrode terminal, a negative electrode terminal, a communication terminal for communicating between the control unit and the external device, and the signal terminal.

8. The battery pack according to claim 7, wherein each of the communication terminal and the signal terminal is a single terminal.

9. An electric device system, comprising: the battery pack according to any one of claims 1 to 8; and the electric device main body that is capable of being connected to the battery pack,
wherein the electric device main body comprises:
a control unit; and
a device-side signal terminal which is connected to the signal terminal of the battery pack and to which the charging/discharging prohibition signal is input.

10. An electric device system, comprising: the battery pack according to any one of claims 1 to 9; and the charging device main body for charging the battery pack,
wherein the charging device main body comprises:
a charging circuit;
a control unit for controlling charging; and
a device-side signal terminal which is connected to the signal terminal of the battery pack and to which the charging/discharging prohibition signal is input.

11. The electric device system according to claim 10, comprising:
a switch for switching the output and cutoff of charging power from the charging circuit to the battery pack; and
a switching circuit for switching ON/OFF of the switch based on a signal indicating a result of determining whether or not charging is capable of being performed by the control unit and a signal received by the signal terminal,
wherein the switching circuit turns on the switch when the signal indicating the determined result is at a level that indicates charging is capable of being performed and the signal received by the signal terminal is at a level indicating charging permission, and turns off the switch otherwise.

12. The electric device system according to claim 11, comprising a cutoff circuit that cuts off a signal input from the signal terminal to the switching circuit when the voltage of the battery pack is equal to or lower than a predetermined value.

13. An electric device system, comprising: the battery pack according to any one of claims 1 to 8, the electric device main body that is capable of being connected to the battery pack, and the charging device main body for charging the battery pack,
wherein the electric device main body comprises a device-side control unit, and a device-side signal terminal which is connected to the signal terminal of the battery pack and to which the charging/discharging prohibition signal is input, and
the charging device main body comprises a charging circuit, a charger-side control unit for controlling charging, and a charger-side signal terminal which is connected to the signal terminal and to which the charging/discharging prohibition signal is input.

14. An electric device system, comprising: a battery pack, an electric device main body that is capable of being connected to the battery pack, and a charging device main body for charging the battery pack,
wherein the battery pack comprises: a battery cell; a control unit for monitoring the state of the battery cell; and a signal terminal that is capable of outputting a charging/discharging prohibition signal to the charging device main body and outputting the charging/discharging prohibition signal to the electric device main body according to the state of the battery cell,
the electric device main body comprises a device-side control unit, and a device-side signal terminal which is connected to the signal terminal of the battery pack and to which the charging/discharging prohibition signal is input,
the charging device main body comprises: a charging circuit; a charger-side control unit for controlling charging; and a charger-side signal terminal which is connected to the signal terminal and to which the charging/discharging prohibition signal is input,
the electric device system is configured to stop the charging/discharging prohibition signal or change the charging/discharging prohibition signal to a signal when the battery cell is normal when the battery pack is connected to the electric device main body in a state that the charging/discharging prohibition signal is output from the battery pack, and
the electric device system is configured to stop the charging/discharging prohibition signal or change the charging/discharging prohibition signal to a signal when the battery cell is normal when the battery pack is connected to the charging device main body in the state that the charging/discharging prohibition signal is output from the battery pack.
